# EUROPEAN PATENT APPLICATION

(11) **EP 4 766 117 A1**
(43) Date of publication of application: **24.06.2026**
(21) Application number: 25216477.7
(22) Date of filing: 17.11.2025
(51) Int. Cl.: H10K 59/122, H10K 59/131, H10K 59/80, H10K 59/38

(54) **DISPLAY DEVICE, METHOD OF MANUFACTURING THE SAME, AND ELECTRONIC DEVICE INCLUDING THE DISPLAY DEVICE**

(30) Priority: 23.12.2024 KR 20240194551
(71) Applicant: Samsung Display Co., Ltd., Yongin-si, Gyeonggi-do 17113 (KR)
(72) Inventor: PARK, Jae-Hyun, 17113 Yongin-si (KR)
(74) Representative: Marks & Clerk LLP

(57) **Abstract**

A display device is disclosed that includes a substrate, a thin film transistor on the substrate, an insulating layer on the thin film transistor; and a light-emitting element. The light-emitting element is positioned on the insulating layer and includes a pixel electrode electrically connected to the thin film transistor, a common electrode facing the pixel electrode, and an interlayer between the pixel electrode and the common electrode. A pixel definition film is positioned on the insulating layer and covers an edge of the pixel electrode to define a light-emitting area of the light-emitting element. The common electrode includes a first common electrode on the light-emitting area, a second common electrode spaced apart from the first common electrode and surrounding the light-emitting area and positioned on the pixel definition film, and a bridge electrode connecting the first common electrode to the second common electrode.

## Description

### BACKGROUND

### 1. Field

Embodiments relate to a display device, a method of manufacturing the same, and an electronic device including the display device.

### 2. Description of the Related Art

Display devices of various types for cell phones, personal digital assistants (PDAs), computers, and large-screen TVs are being developed. Display devices widely used in the market include liquid crystal displays equipped with a backlight unit and light-emitting display devices that include organic light emitting diodes.

Recently, to reduce costs and improve luminescence efficiency for some display devices, polarizing layers are not being used and color filters are being added. In addition, display devices are being developed that maintain luminescence efficiency while simplifying the method of manufacturing them.

### SUMMARY

Embodiments of the disclosure provide a display device having improved reliability and a simplified process, a manufacturing method thereof, and an electronic device.

However, the technical problems to be solved by the disclosure are not limited to the problems described above, and other problems not described may be clearly understood by those skilled in the art from the description of the disclosure described below.

An embodiment of a display device includes: a substrate; a thin film transistor on the substrate; an insulating layer on the thin film transistor; a light-emitting element positioned on the insulating layer and including a pixel electrode electrically connected to the thin film transistor, a common electrode facing the pixel electrode, and an interlayer between the pixel electrode and the common electrode; and a pixel definition film positioned on the insulating layer and covering an edge of the pixel electrode to define a light-emitting area of the light-emitting element; wherein the common electrode includes a first common electrode in the light-emitting area, a second common electrode spaced apart from the first common electrode and surrounding the light-emitting area and positioned on the pixel definition film, and a bridge electrode connecting the first common electrode to the second common electrode.

In an embodiment, the pixel definition film may further include a spacer in an isolation area defined between the first common electrode and the second common electrode.

In an embodiment, the spacer may discontinuously surround the light-emitting area and the bridge electrode located in a region where the spacer is disconnected.

In an embodiment, the width of the bridge electrode along a direction perpendicular to the direction in which the first common electrode and the second common electrode are connected to each other may be 2 µm to 10 µm.

In an embodiment, the bridge electrode connected to the first common electrode may be provided as a plurality of bridge electrodes, and the plurality of bridge electrodes may be arranged spaced apart from each other in a direction perpendicular to the direction in which the first common electrode is connected to the second common electrode.

In an embodiment, the pixel definition film may have liquid repellency.

In an embodiment, the pixel definition film may include a light-blocking material.

In an embodiment, a color filter part arranged on the light-emitting element may be further included.

In an embodiment, the color filter part may be located in the light-emitting area.

In an embodiment, the color filter part may have an upwardly convex shape.

In an embodiment, a thin-film encapsulation layer may further be included that is arranged on the color filter part.

An embodiment of a method of manufacturing a display device includes: forming a substrate, a thin film transistor on the substrate, and an insulating layer on the thin film transistor; and forming, on the insulating layer, a light-emitting element including a pixel electrode electrically connected to the thin film transistor, a common electrode facing the pixel electrode, and an interlayer between the pixel electrode and the common electrode, and a pixel definition film covering an edge of the pixel electrode to define a light-emitting area of the light-emitting element, wherein the common electrode includes a first common electrode in the light-emitting area, a second common electrode spaced apart from the first common electrode and surrounding the light-emitting area, and positioned on the pixel definition film, and a bridge electrode connecting the first common electrode to the second common electrode.

In an embodiment, the forming the light-emitting element and the pixel definition film may include forming the pixel electrode; forming the pixel definition film at an edge of the pixel electrode using a half-tone mask; forming the interlayer on the pixel electrode; and forming the common electrode on the pixel definition film and the interlayer.

In an embodiment, after the forming the common electrode on the pixel definition film and the interlayer, the method may further include forming a spacer by patterning the common electrode on one area of the pixel definition film, wherein the spacer may be arranged between the first common electrode and the second common electrode.

In an embodiment, after the forming the spacer, the method may further include treating the spacer with a plasma having liquid repellency.

In an embodiment, after the forming the light-emitting element and the pixel definition film, the method may further include forming a color filter part on the first common electrode.

In an embodiment, a space between the first common electrode and the second common electrode is defined as an isolation area, and in the isolation area, the spacer discontinuously surrounding the light-emitting area and the bridge electrode positioned in an area where the spacer is disconnected may be arranged.

In an embodiment, the width of the bridge electrode along a direction perpendicular to the direction in which the first common electrode and the second common electrode are connected to each other may be 2 µm to 10 µm.

In an embodiment, the pixel definition film may have liquid repellency.

An embodiment of an electronic device includes a display device, one or more processors, a memory, and a power module, wherein the display device includes: a substrate; a thin film transistor on the substrate; an insulating layer on the thin film transistor; a light-emitting element positioned on the insulating layer and including a pixel electrode electrically connected to the thin film transistor, a common electrode facing the pixel electrode, and an interlayer between the pixel electrode and the common electrode; and a pixel definition film positioned on the insulating layer and covering an edge of the pixel electrode to define a light-emitting area of the light-emitting element; wherein the common electrode includes a first common electrode in the light-emitting area, a second common electrode spaced apart from the first common electrode and surrounding the light-emitting area and positioned on the pixel definition film, and a bridge electrode connecting the first common electrode and the second common electrode.

At least some of the above and other features of the invention are set out in the claims.

### BRIEF DESCRIPTION OF THE DRAWINGS

The following drawings attached to this specification illustrate preferred embodiments of the disclosure and, together with the detailed description of the disclosure described below, serve to further understand the technical idea of the disclosure; therefore, the disclosure should not be interpreted as being limited to matters described in such drawings in which:
FIG. 1 is a plan view schematically illustrating a part of a display device according to an embodiment of the disclosure.
FIG. 2 shows an enlarged view schematically illustrating an enlarged example of area A of FIG. 1.
FIG. 3 shows a cross-sectional view schematically illustrating an example of a cross-section along line I-I' of FIG. 2.
FIG. 4 shows a cross-sectional view schematically illustrating an example of a cross-section along line II-II' of FIG. 2.
FIGS. 5, 6, and 7 show cross-sectional views to illustrate a method of manufacturing a display device according to an embodiment of the disclosure.
FIG. 8 shows a block diagram of an electronic device according to an embodiment of the disclosure.
FIG. 9 shows schematic diagrams of electronic devices according to various embodiments.

### DETAILED DESCRIPTION

The disclosure may undergo various modifications and have various embodiments, and specific embodiments are illustrated in the drawings and described in detail in the detailed description. The effects and features of the disclosure and the method of achieving them will become clear with reference to the embodiments described in detail below together with the drawings. However, the disclosure is not limited to the embodiments disclosed below and may be implemented in various forms.

In embodiments below, the terms "first", "second", etc. are not used in a limiting sense but are used for the purpose of distinguishing one component from another component.

In embodiments below, singular expressions include plural expressions unless the context clearly indicates otherwise.

In embodiments below, terms such as "comprise," "include," and "have" indicate that a feature or component described in the specification is present, and do not exclude in advance the possibility that one or more other features or components may be added.

As used herein, the word "or" means logical "or" so that, unless the context indicates otherwise, the expression "A, B, or C" means "A and B and C," "A and B but not C," "A and C but not B," "B and C but not A," "A but not B and not C," "B but not A and not C," and "C but not A and not B."

In embodiments below, when it is said that a part such as a unit, region, or component is located above or on another part, this includes not only the case where it is directly above the other part, but also the case where another unit, region, component, etc. is interposed in between.

In embodiments below, terms such as connect or couple do not necessarily imply a direct or fixed connection or coupling of two members, unless the context clearly indicates otherwise, and do not exclude the presence of another member between the two members.

In the drawings, the sizes of components may be exaggerated or reduced for convenience of explanation. For example, the size or thickness of each component shown in the drawings are arbitrarily shown for convenience of explanation, and therefore the disclosure is not necessarily limited to what is shown.

Hereinafter, preferred embodiments of the disclosure will be described in detail with reference to the attached drawings. When describing with reference to the drawings, identical or corresponding components are given the same drawing reference numerals and redundant descriptions thereof will be omitted.

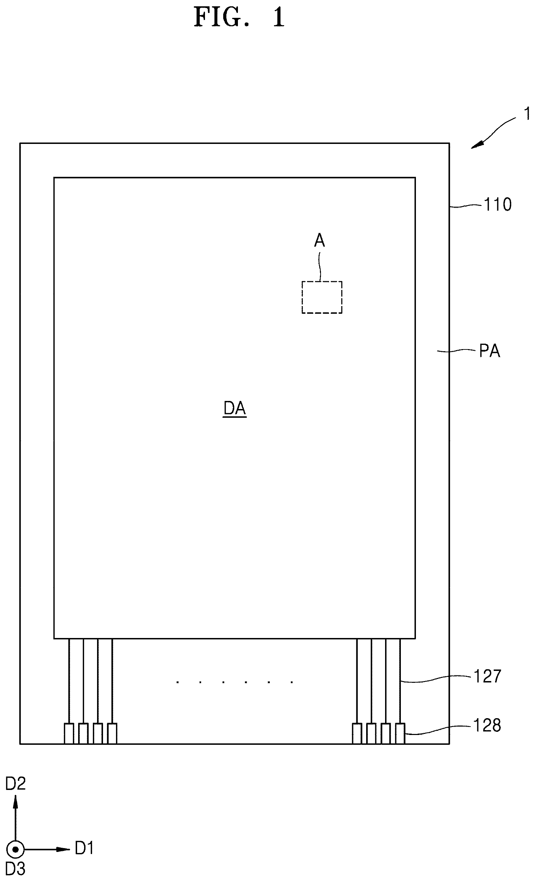

FIG. 1 is a plan view schematically illustrating a part of a display device 1 according to an embodiment of the disclosure.

Referring to FIG. 1, the display device 1 may include, on a substrate 110, a display area DA in which an image is displayed and a peripheral area PA which is a non-display area located outside the display area DA and in which no image is displayed.

The display area DA may be rectangular. The peripheral area PA may surround the display area DA. However, embodiments are not limited thereto, the shape of the display area DA and the shape of the peripheral area PA may be designed relatively.

The display device 1 may generate an image and provide the same to a user. The display device 1 may be a liquid crystal display device, an organic light-emitting display device including an organic light-emitting diode (OLED) or a quantum dot electroluminescence (QD-EL) device, an electrophoretic display device, or an electrowetting display device, or any one of various other display devices capable of displaying an image.

Quantum dots are semiconductor materials with a crystal structure that is a few nanometers in size and consist of hundreds to thousands of atoms. Because quantum dots are very small in size, they have a large surface area per unit volume, most atoms exist on the surface of the nanocrystal, and they exhibit quantum confinement effects. Due to the effect of quantum confinement, the emission wavelength may be controlled simply by adjusting the size of the quantum dot, and excellent color purity and high photoluminescence (PL) emission efficiency may be obtained. A quantum dot electroluminescence (QD-EL) device may be a device having a three-layer structure in which a hole transport layer (HTL) and an electron transport layer (ETL) are respectively arranged at opposite ends with a quantum dot emission layer in between.

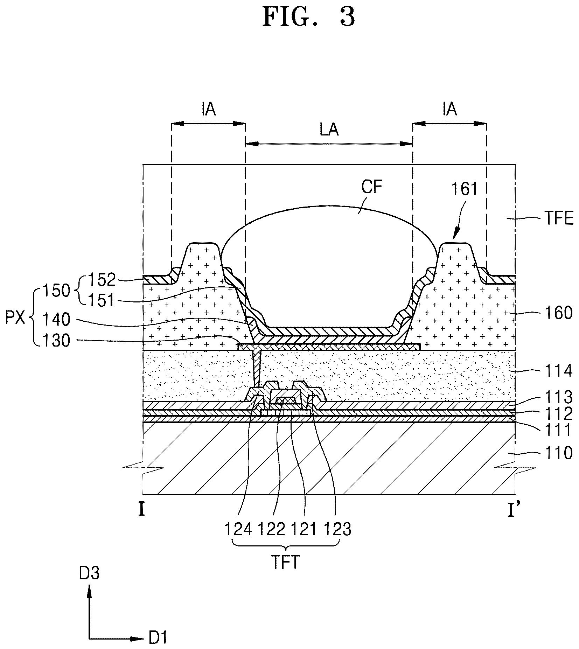

In the display area DA, a plurality of light-emitting elements PX (see FIG. 3) are included, and a wiring part 127 may be electrically connected to a pad electrode 128, wherein the wiring part 127 includes signal lines such as scan lines and data lines, and power lines such as driving voltage lines, which are electrically connected to the plurality of light-emitting elements PX (see FIG. 3).

In an embodiment of the disclosure, the display device 1 having a flat display surface is illustrated, but is not limited thereto. The display device 1 may include a curved display surface or a three-dimensional display surface. A three-dimensional display surface may include a plurality of display areas pointing in different directions, and may include, for example, a polygonal columnar display surface.

The display device 1 according to an embodiment may be a rigid display device. However, embodiments are not limited thereto, and the display device 1 according to the disclosure may be a flexible display device.

The display device 1 is being developed to improve luminescence efficiency and reduce cost by simplifying the process, for example, by removing the polarization layer and applying a color filter. Hereinafter, a display device having improved reliability while simplifying the process by patterning a common electrode is described.

Various features shown in Fig. 1 and other figures may be defined with respect to a first direction D1, a second direction D2 crossing the first direction D1, and a third direction D3 crossing the first and second directions D1 and D2.

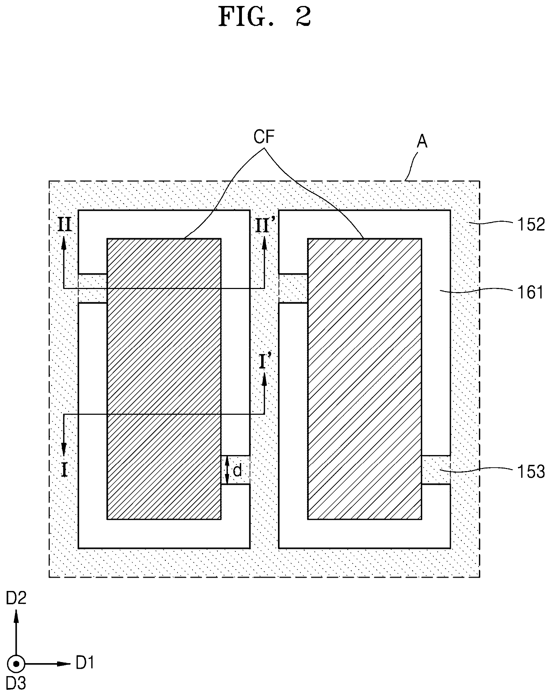

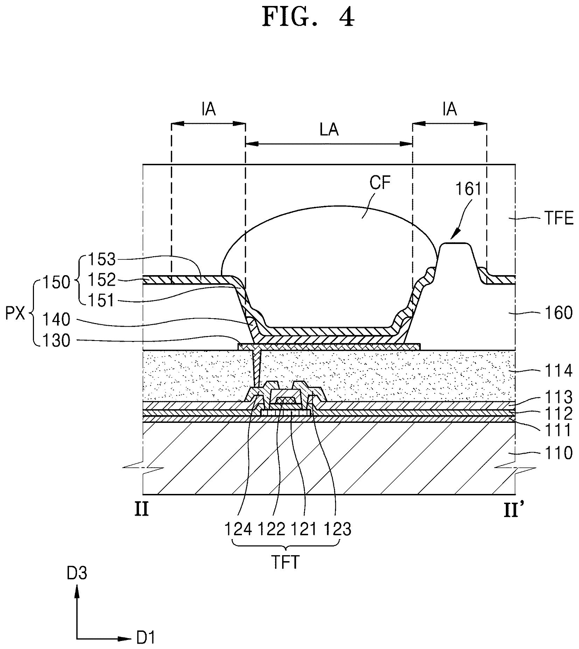

FIG. 2 shows an enlarged view schematically illustrating an enlarged example of area A of FIG. 1, FIG. 3 shows a cross-sectional view schematically illustrating an example of a cross-section along line I-I' of FIG. 2, and FIG. 4 shows a cross-sectional view schematically illustrating an example of a cross-section along line II-II' of FIG. 2.

Referring to FIGS. 2 to 4, the display device 1 includes the substrate 110, a thin film transistor TFT on the substrate 110, an insulating layer 114 on the thin film transistor TFT, the light-emitting element PX on the insulating layer 114, and a pixel definition film 160 on the insulating layer 114. The display device 1 may additionally include a color filter part CF on the light-emitting element PX.

The substrate 110 may include various materials such as glass, metal, or plastic. For example, the substrate 110 may be a flexible substrate including a polymer resin such as polyethersulphone, polyacrylate, polyetherimide, polyethylene naphthalate, polyethylene terephthalate, polyphenylene sulfide, polyallylate, polyimide, polycarbonate, or cellulose acetate propionate.

A plurality of thin film transistors TFTs may be arranged on the substrate 110. The display area DA may be an area for displaying an image, in which a plurality of thin film transistors TFTs and a plurality of light-emitting elements PXs which are electrically connected to the plurality of thin film transistors TFTs, respectively, may be arranged.

A buffer layer 111 including an inorganic material such as silicon oxide, silicon nitride, or silicon oxynitride may be arranged between the thin film transistor TFT and the substrate 110. The buffer layer 111 may increase the smoothness of an upper surface of the substrate 110 or prevent or reduce the penetration of impurities into a semiconductor layer 121 through the substrate 110.

The thin film transistor TFT may include the semiconductor layer 121, a gate electrode 122, a source electrode 123, and a drain electrode 124.

The thin film transistor TFT may be disposed on the substrate 110, specifically on the buffer layer 111.

The semiconductor layer 121 may include amorphous silicon, polycrystalline silicon, or an organic semiconductor material.

The gate electrode 122 may be disposed on the semiconductor layer 121. The source electrode 123 and the drain electrode 124 may be electrically communicated depending on a signal applied to the gate electrode 122. The gate electrode 122 may be formed as a single layer or multiple layers using one or more materials selected from aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu), in consideration of adhesion to adjacent layers, surface flatness of laminated layers, and processability.

In order to secure insulation between the semiconductor layer 121 and the gate electrode 122, a gate insulating film 112 including an inorganic material such as silicon oxide, silicon nitride, or silicon oxynitride may be disposed between the semiconductor layer 121 and the gate electrode 122.

An interlayer insulating film 113 including an inorganic material such as silicon oxide, silicon nitride, or silicon oxynitride may be disposed on the gate electrode 122.

The source electrode 123 and the drain electrode 124 may be arranged on the interlayer insulating film 113. The source electrode 123 and the drain electrode 124 may be electrically connected to the semiconductor layer 121 through contact holes formed in the interlayer insulating film 113 and the gate insulating film 112, respectively.

The source electrode 123 and the drain electrode 124 may be formed as a single layer or multiple layers using one or more materials selected from aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu).

Various structures and wiring may be arranged in the peripheral area PA of the substrate 110. For example, the wiring may include a first power supply line for applying low-voltage power to the light-emitting element PX, and a second power supply line for applying high-voltage power to the light-emitting element PX.

The insulating layer 114 that acts as a planarizing film is disposed on the thin film transistor TFT. The insulating layer 114 may include an organic insulator or an inorganic insulator, or may include a composite form of an organic insulator and an inorganic insulator. For example, the insulating layer 114 may include organic materials such as acrylic resin, benzocyclobutene (BCB), polyimide, or hexamethyldisiloxane (HMDSO).

In the display area DA, the light-emitting element PX electrically connected to the thin film transistor TFT is disposed on the insulating layer 114.

The light-emitting element PX may include a plurality of light-emitting elements PX arranged spaced apart from each other. In an embodiment, the light-emitting element PX may include a plurality of light-emitting elements PX respectively emitting red light, green light, and blue light.

The light-emitting element PX includes a pixel electrode 130 electrically connected to the thin film transistor TFT, a common electrode 150 facing the pixel electrode 130, and an interlayer 140 arranged between the pixel electrode 130 and the common electrode 150.

The pixel electrode 130 may be disposed on the insulating layer 114. The pixel electrode 130 may be connected to the drain electrode 124 of a thin film transistor TFT through a via hole (not shown) formed in the insulating layer 114.

The pixel electrode 130 may have conductivity. The pixel electrode 130 may include a metal alloy or a conductive compound. The pixel electrode 130 may be an anode.

The pixel electrode 130 may be a transmissive electrode, a semi-transmissive electrode, or a reflective electrode. In the case that the pixel electrode 130 is a transmissive electrode, the pixel electrode 130 may include a transmissive metal oxide, for example, indium tin oxide (ITO), indium zinc oxide (IZO), zinc oxide (ZnO), indium tin zinc oxide (ITZO), etc.

In the case that the pixel electrode 130 is a semi-transmissive electrode or a reflective electrode, the pixel electrode 130 may include Ag, Mg, Cu, Al, Pt, Pd, Au, Ni, Nd, Ir, Cr, Li, Ca, LiF/Ca, LiF/Al, Mo, Ti, or a compound or mixture thereof (for example, a mixture of Ag and Mg). In some embodiments, the pixel electrode 130 may have a multi-layer structure including a reflective film or a semi-transmissive film including these materials and a transmissive conductive film including indium tin oxide (ITO), indium zinc oxide (IZO), zinc oxide (ZnO), indium tin zinc oxide (ITZO), etc. For example, the pixel electrode 130 may have a three-layer structure of ITO/Ag/ITO, but is not limited thereto.

The interlayer 140 may be disposed on the pixel electrode 130 and in the opening where one area of the pixel definition film 160 is removed.

The interlayer 140 may be a single layer consisting of a single material, a single layer consisting of multiple different materials, or may have a multi-layer structure having a plurality of different materials.

The interlayer 140 may include a low molecular weight or high molecular weight material. In the case that the interlayer 140 includes a low-molecular-weight material, the interlayer may have such a structure that each of a hole injection layer, a hole transport layer, an electron transport layer, and an electron injection layer are laminated in a single structure or a composite structure. The interlayer 140 may include various organic substances, including copper phthalocyanine, N,N-dinaphthalene-1-yl-N,N'-diphenyl-benzidine (NPB), and tris-8-hydroxyquinoline aluminium (Alq3). The interlayer 140 may be formed by various methods, such as vacuum deposition.

In the case that the interlayer 140 includes a high molecular weight material (e.g., a polymer material), the interlayer 140 may usually include a hole transport layer. In this regard, the hole transport layer may include PEDOT, and the emission layer may include a polymer material such as a poly-phenylenevinylene (PPV)-based material and a polyfluorene-based material. The interlayer 140 may be formed by various methods, such as screen printing, inkjet printing, and laser induced thermal imaging (LITI).

The interlayer 140 may be a layer formed integrally across a plurality of pixel electrodes 130, or may be a layer patterned to correspond to each of the plurality of pixel electrodes 130.

The common electrode 150 formed integrally with all light-emitting elements PX may be formed on the interlayer 140 of each light-emitting element PX.

The common electrode 150 includes a first common electrode 151 on the light-emitting area LA, a second common electrode 152 spaced apart from the first common electrode 151 and surrounding the light-emitting area LA and positioned on the pixel definition film 160, and a bridge electrode 153 connecting the first common electrode 151 to the second common electrode 152.

The first common electrode 151 may be disposed on the interlayer 140 and in the opening where one area of the pixel definition film 160 is removed. The first common electrode 151 may be disposed between the interlayer 140 and the color filter part CF.

The second common electrode 152 may be disposed on the pixel definition film 160 so as not to overlap with the light-emitting area LA. The second common electrode 152 may be disposed between the pixel definition film 160 and the thin-film encapsulation layer TFE. The second common electrode 152 may be disposed spaced apart from the first common electrode 151.

An area between the first common electrode 151 and the second common electrode 152 may be defined as an isolation area IA. In the isolation area IA, a spacer 161, which is an area of the pixel definition film 160 that discontinuously surrounds the light-emitting area LA, and a bridge electrode 153 located in an area where the spacer 161 is disconnected may be disposed.

The bridge electrode 153 may be disposed on the pixel definition film 160 in the isolation area IA between the first common electrode 151 and the second common electrode 152. The bridge electrode 153 may connect the first common electrode 151 to the second common electrode 152. As a result, an identical common voltage may be applied to each light-emitting element PX.

A width d of the bridge electrode 153 along the direction perpendicular to the direction of the first common electrode 151 and the second common electrode 152 are connected to each other, may be, for example, 2 µm to 10 µm. In the case that the width d of the bridge electrode 153 is less than 2 µm, the resistance of the bridge electrode 153 increases, causing a drop in the common voltage transmitted to the first common electrode 151, which may deteriorate the display quality of the display device 1. On the other hand, in the case that the width d of the bridge electrode 153 is greater than 10 µm, an ink-type color filter part CF applied on the first common electrode 151 may leak out of the light-emitting area LA through the bridge electrode 153.

The bridge electrode 153 connected to one first common electrode 151 may be provided as at least one bridge electrode. In an embodiment, in the case that a plurality of bridge electrodes 153 are connected to one first common electrode 151, the plurality of bridge electrodes 153 may be arranged spaced apart from each other in a direction perpendicular to the direction in which the first common electrode 151 and the second common electrode 152 are connected to each other.

Since there are a plurality of light-emitting elements PX, bridge electrodes 153 arranged on the surfaces of first common electrodes 151 facing each other in two most adjacent first common electrodes 151 may be arranged spaced apart from each other in a direction perpendicular to the direction in which the first common electrode 151 and the second common electrode 152 are connected to each other. As a result, ink overflow of the color filter part CF on the first common electrode 151 adjacent thereto due to interference of the bridge electrode 153 may be prevented.

The common electrode 150 may be a transmissive electrode, a semi-transmissive electrode, or a reflective electrode. In the case that the common electrode 150 is a transmissive electrode, the common electrode 150 may include a transmissive metal oxide, for example, indium tin oxide (ITO), indium zinc oxide (IZO), zinc oxide (ZnO), indium tin zinc oxide (ITZO), etc.

The common electrode 150 may be formed as a semi-transmissive electrode. In the case that the common electrode 150 is formed as a semi-transmissive electrode, the common electrode 150 may include one or more materials selected from Ag, Al, Mg, Li, Ca, Cu, LiF/Ca, LiF/Al, MgAg, and CaAg, and may be formed in the form of a thin film having a thickness of several to several tens of nm.

On the insulating layer 114, the pixel definition film 160 may be formed between the pixel electrodes 130 of each light-emitting element PX and the common electrode 150.

The pixel definition film 160 covers the edge of each pixel electrode 130 to define the light-emitting area LA of the light-emitting element PX.

The pixel definition film 160 may have liquid repellency. In an embodiment, the pixel definition film 160 may have hydrophobicity. As a result, the color filter part CF may not overflow onto the pixel definition film 160 that has liquid repellency.

The pixel definition film 160 may further include the spacer 161 in the isolation area IA between the first common electrode 151 and the second common electrode 152. That is, the common electrode 150 may be arranged entirely on the pixel definition film 160 except for the spacer 161.

The spacer 161 may be disposed on the outside of the light-emitting area LA. In other words, the spacer 161 may be arranged to surround the first common electrode 151.

In some embodiments, the spacer 161 may not completely surround the light-emitting area LA and the first common electrode 151. The spacer 161 may not exist in at least the light-emitting area LA and one area of the edge of the first common electrode 151, and the bridge electrode 153 may be arranged in the region where the spacer 161 does not exist. In other words, the edge of the light-emitting area LA is mainly surrounded by the spacer 161, and the bridge electrode 153 may be disposed in the area where the spacer 161 is disconnected.

The common electrode 150 may be disposed on the pixel definition film 160 and the light-emitting area LA excluding the spacer 161. As a result, the liquid repellency of the surface may disappear by the common electrode 150, which may cause defects in the process of forming a color filter part CF formed by inkjet process.

The common electrode 150 may not be disposed on the spacer 161. That is, because the common electrode 150 is arranged on the pixel definition film 160 having liquid repellency, the disappeared liquid repellency may be compensated for by the spacer 161 on which the common electrode 150 is not arranged.

Since the common electrode 150 is not arranged on the spacer 161, the color filter part CF may not overflow beyond the spacer 161 having liquid repellency.

In some embodiments, the spacer 161 may protrude further in the direction in which light is emitted than other areas of the pixel definition film 160 excluding the spacer 161. As a result, the color filter part CF may not overflow beyond the spacer 161.

The pixel definition film 160 may include an organic material, such as polyimide or hexamethyldisiloxane (HMDSO). In some embodiments, the pixel definition film 160 may be formed to surround the periphery of each pixel electrode 130 and may include a light-blocking material. The light-blocking material may include, for example, at least one of carbon black, carbon nanotubes (CNTs), or black dye.

The pixel definition film 160 may act as a black matrix of the related art. The pixel definition film 160 may include a material capable of blocking light. The pixel definition film 160 may include a general material for a liquid-repellent pixel definition film used when forming a general inorganic light-emitting element. In an embodiment, the pixel definition film 160 may include at least one of a metal oxide such as chromium oxide (CrOx), an opaque organic film material, carbon black, carbon nanotubes, or black dye. The pixel definition film 160 may include a coloring agent such as a pigment or a dye. The pixel definition film 160 may have a single-layer structure or a multi-layer structure.

The color filter part CF may be disposed on the light-emitting element PX, for example, between the first common electrode 151 and the thin-film encapsulation layer TFE. The color filter part CF may be located in the light-emitting area LA.

The color filter part CF may include color filters that filter light generated from the light-emitting element PX and transmit the same to the outside. The color filters may include a plurality of colors corresponding to the light-emitting areas of the light-emitting elements PX. For example, in the case that one light-emitting element PX emits red light, the color filter on the light-emitting element PX may filter the red light, in the case that the light-emitting element PX emits green light, the color filter on the light-emitting element PX may filter the green light, and in the case that the light-emitting element PX emits blue light, the color filter on the light-emitting element PX may filter the blue light.

By applying the color filter part CF instead of a polarizing layer to the display device 1, the light emission efficiency may be improved. According to the disclosure, the manufacturing process can be simplified by forming the color filter part CF directly on the light-emitting element PX.

The color filter part CF may be formed by an ink-jet process and thus may have an upwardly convex shape.

A thin-film encapsulation layer TFE covering the display area DA may be disposed on the color filter part CF. The thin-film encapsulation layer TFE may seal the light-emitting element PX and prevent deterioration of the light-emitting element PX caused by moisture and oxygen contained in the external air.

The thin-film encapsulation layer TFE may include a first inorganic layer, an organic layer, and a second inorganic layer, which are not shown, and may be sequentially laminated.

The first inorganic layer may include silicon oxide, silicon nitride or silicon oxynitride.

The organic layer may cover the first inorganic layer, which is not flat, and the upper surface of the organic layer may be substantially flat. The organic layer may include one or more materials selected from the group consisting of polyethylene terephthalate, polyethylene naphthalate, polycarbonate, polyimide, polyethylene sulfonate, polyoxymethylene, polyarylate, and polyacrylate hexamethyldisiloxane.

The second inorganic layer may cover the organic layer and may include silicon oxide, silicon nitride or silicon oxynitride.

Since the thin-film encapsulation layer TFE has a multi-layer structure including a first inorganic layer, an organic layer, and a second inorganic layer, when a crack occurs within the thin-film encapsulation layer TFE, the crack may be prevented from connecting with each other between the first inorganic layer and the organic layer or between the organic layer and the second inorganic layer. This may prevent or reduce the formation of a path through which moisture or oxygen from the outside may penetrate into the display area DA.

Meanwhile, although not shown, a capping layer (not shown) may be further provided between the common electrode 150 and the thin-film encapsulation layer TFE to improve light efficiency and protect the light-emitting element.

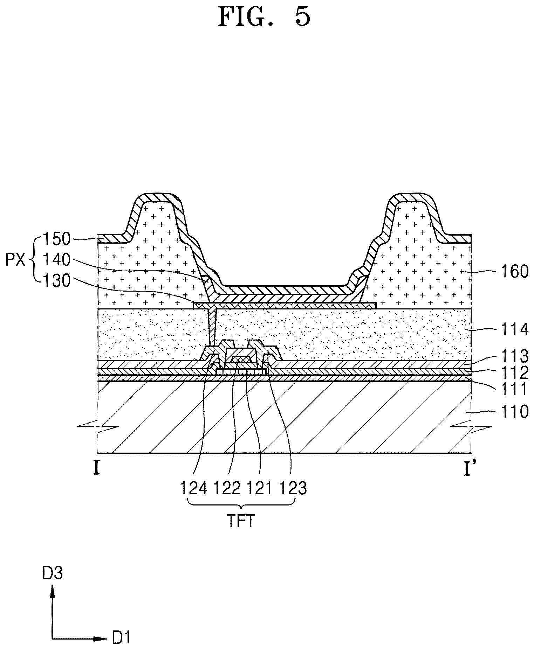

FIGS. 5 to 7 show cross-sectional views to illustrate a method of manufacturing a display device according to an embodiment of the disclosure. In some embodiments, the manufacturing process of a display device according to an embodiment of the disclosure will be described below along the line I-I' of FIG. 2.

A simple process for manufacturing the display device 1 according to the disclosure may include forming the substrate 110, the thin film transistor TFT on the substrate 110, and the insulating layer 114 on the thin film transistor TFT, and forming, on the insulating layer 114, the light-emitting element PX including the pixel electrode 130 electrically connected to the thin film transistor TFT, the common electrode 150 facing the pixel electrode 130, and the interlayer 140 between the pixel electrode 130 and the common electrode 150, and the pixel definition film 160 that covers the edge of the pixel electrode 130 to define the light-emitting area LA of the light-emitting element PX.

The forming the light-emitting element PX and the pixel definition film 160 on the insulating layer 114, which is performed after sequentially stacking of the substrate 110, the thin film transistor TFT, and the insulating layer 114, will now be described in detail.

Referring to FIG. 5, the forming the light-emitting element PX and the pixel definition film 160 may include forming the pixel electrode 130, forming the pixel definition film 160 using a half-tone mask at the edge of the pixel electrode 130, forming the interlayer 140 on the pixel electrode 130, and forming the common electrode 150 on the pixel definition film 160 and the interlayer 140.

That is, the common electrode 150 may be formed entirely on the pixel definition film 160 and the interlayer 140. By using a pixel definition film 160 having liquid repellency, the color filter part CF may be arranged as designed, and the ink that will become the color filter part CF may be dropped at a desired location. The pixel definition film 160 may replace a black matrix since the pixel definition film 160 has liquid repellency and contains a light-blocking material. Since the color filter part is disposed directly on the light-emitting element PX, the number of masks may be reduced, simplifying the process.

However, in the case that the common electrode 150 is disposed on the pixel definition film 160 and the interlayer 140 and the color filter part CF is formed thereon, the liquid repellency of the pixel definition film 160 disappears due to the common electrode 150, and the ink of the color filter part CF may overflow contrary to the design. That is, the risk of defects occurring in the ink-jet process for forming the color filter part CF may be increased.

This issue can be addressed by utilizing the liquid repellency of the pixel definition film 160. In detail, a step may be formed on the pixel definition film 160 using a half-tone mask, and then a portion of the common electrode 150 corresponding to one area of the pixel definition film 160 may be removed in the following processes.

The forming a pixel definition film 160 using a half-tone mask is specifically as follows: forming a photoresist layer by coating a photoresist material on a pixel definition film 160, forming a photoresist pattern on the photoresist layer using a half-tone mask, and a patterning the pixel definition film 160 using the photoresist pattern as a mask.

The halftone mask may adjust the width and depth of each area of the pixel definition film 160 by adjusting the transmittance and width of each area for a desired design. By using a halftone mask when forming a photoresist pattern, there is no additional mask increase, simplifying the process and reducing manufacturing costs and process time.

In some embodiments, a photoresist pattern may be formed by performing an exposure process and a development process on a photoresist layer while placing a halftone mask on the photoresist material, that is, on the photoresist layer.

After forming a photoresist pattern, the pixel definition film 160 may be patterned using the photoresist pattern as a mask, i.e., an etching process may be performed on the photoresist pattern.

After patterning the pixel definition film 160, when a strip step is performed to remove the remaining photoresist pattern, a step may be formed in the pixel definition film 160.

In this regard, the area of the pixel definition film 160 with a higher step is the area where the spacer 161 will be formed later, and the second common electrode 152 and the bridge electrode 153 may be disposed on the area of the pixel definition film 160 with a lower step. In some embodiments, the pixel definition film 160 may be patterned such that the width of the bridge electrode 153 along the direction perpendicular to the connection direction of the first common electrode 151 and the second common electrode 152 may be 2 µm to 10 µm.

The pixel definition film 160 may be formed such that a portion thereof that will later become the spacer 161 protrudes more in the direction in which light is emitted than another portion thereof that will not become the spacer 161. In some embodiments, the light transmittance of the halftone mask on the portion to be the spacer 161 may be adjusted to be small so that the portion to be the spacer 161 is formed higher than the other portion of the pixel definition film 160.

In order to maintain the liquid repellency of the pixel definition film 160 and arrange the color filter part CF as designed, after the forming the common electrode 150, the common electrode 150 on one area of the pixel definition film 160 may be patterned to form the spacer 161, corresponding to an area of the pixel definition film 160 where the common electrode 150 is exposed.

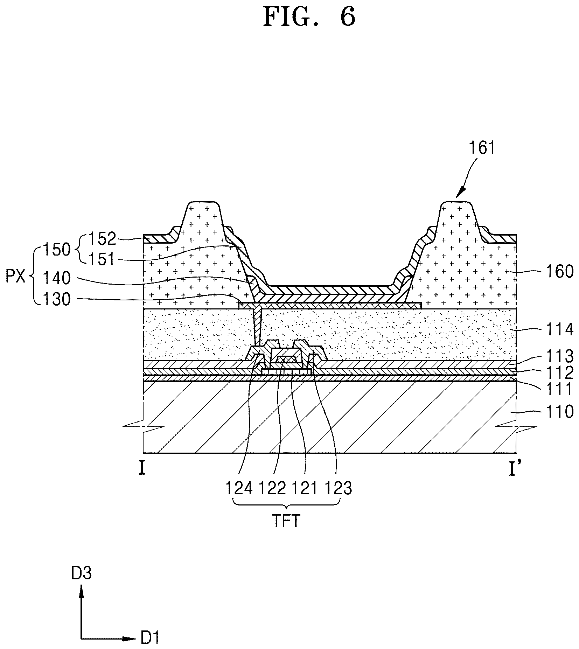

Referring to FIG. 6, in the forming the spacer 161, the portion of the common electrode 150 on the high-step portion of the pixel definition film 160 is removed by a chemical mechanical planarization (CMP) process to form the spacer 161.

In some embodiments, the common electrode 150 on the high-step portion of the pixel definition film 160 may be removed by chemical etching or mechanical polishing to form the spacer 161.

A plasma having liquid-repellent properties may be further applied to treat the spacer 161, which has liquid repellency due to the removal of the common electrode 150, to further enhance the liquid-repellent characteristics, that is, to maximize the surface energy difference. An example of a plasma having liquid repellency is CF₄ plasma. As a result, the liquid-repellent properties may be further enhanced due to the difference in surface properties between the exposed area of the pixel definition film 160, which is an organic film, and the common electrode 150.

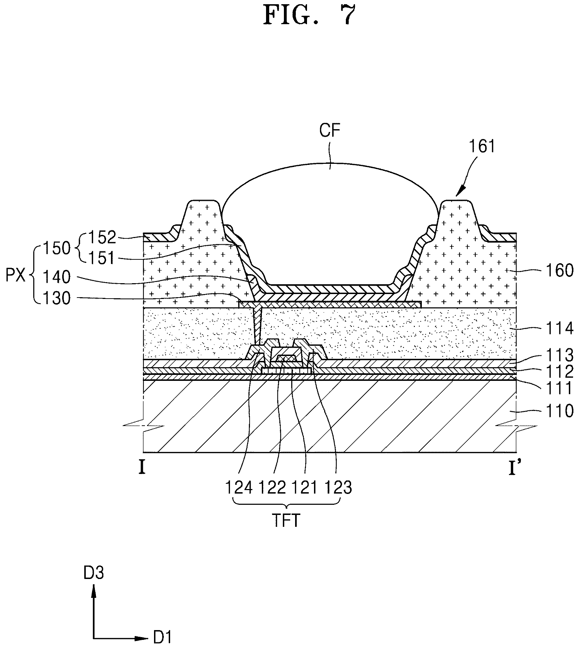

Referring to FIG. 7, after the forming the light-emitting element PX and the pixel definition film 160, the color filter part CF may be arranged on the first common electrode 151.

In some embodiments, the color filter part CF may be disposed in the light-emitting area LA on the first common electrode 151. The color filter part CF may be disposed within the spacer 161.

The color filter part CF may be formed by dropping ink into a spacer 161 on the first common electrode 151.

After the color filter part CF is formed, the thin-film encapsulation layer TFE may be formed on the color filter part CF and the common electrode 150.

The common electrode 150 of the display device 1 manufactured through the processes described above includes the first common electrode 151 on the light-emitting area LA, the second common electrode 152 spaced apart from the first common electrode 151 and surrounding the light-emitting area LA and positioned on the pixel definition film 160, and a bridge electrode 153 connecting the first common electrode 151 to the second common electrode 152.

The spacer 161 and the bridge electrode 153 may be arranged in the isolation area IA defined between the first common electrode 151 and the second common electrode 152. The spacer 161 has a higher step than the other portion of the pixel definition film 160 and discontinuously surrounds the light-emitting area LA, and the bridge electrode 153 is disposed in an area where the spacer 161 is disconnected.

The display device 1 described above can have an increased luminescence efficiency due to the introduction of the color filter part CF, and can be manufactured at lower prices due to the simplified manufacturing process obtained by the arrangement of the color filter part CF on the light-emitting element PX. In addition, by forming the common electrode 150 over the pixel definition film 160 excluding the spacer 161, for example, by forming the bridge electrode 153 in the area where the spacer 161 surrounding the edge of the light-emitting area LA is disconnected, the first common electrode 151 and the second common electrode 152 may be electrically connected to maintain a network.

The display device 1 according to an embodiment may be applied to various electronic devices, for example, an electronic device 1000. The electronic device 1000 according to an embodiment includes the display device 1 described above, and may further include a module or device having additional functions in addition to the display device 1.

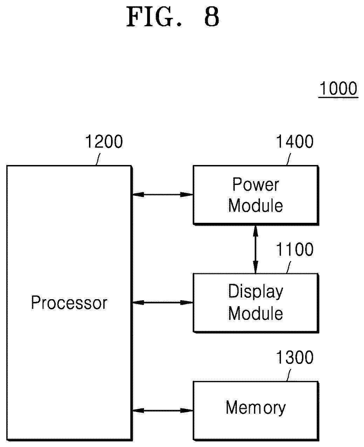

FIG. 8 shows a block diagram of the electronic device 100 according to an embodiment of the disclosure. Referring to FIG. 8, the electronic device 1000 according to an embodiment may include a display module 1100, a processor 1200, a memory 1300, and a power module 1400.

The processor 1200 may include at least one of a central processing unit (CPU), an application processor (AP), a graphic processing unit (GPU), a communication processor (CP), an image signal processor (ISP), and a controller. The processor may be implemented as more than one processor.

Data information necessary for the operation of the processor 1200 or the display module 1100 may be stored in the memory 1300. When the processor 1200 executes an application stored in the memory 1300, an image data signal or an input control signal is transmitted to the display module 1100, and the display module 1100 may process the received signal and output image information through a display screen.

The power module 1400 may include a power supply module, such as a power adapter or a battery device, and a power conversion module that converts power supplied by the power supply module to generate power required for the operation of the electronic device 1000.

At least one of the components of the electronic device 1000 may be included in the display device 1 according to the embodiments described above. Additionally, some of the individual modules which are included within a functionally single module may be included within a display device, while others may be provided separately from the display device. For example, the display device 1 may include a display module 1100, and the processor 1200, the memory 1300, and the power module 1400 may be provided in the form of other devices within the electronic device 1000, not the display device 1.

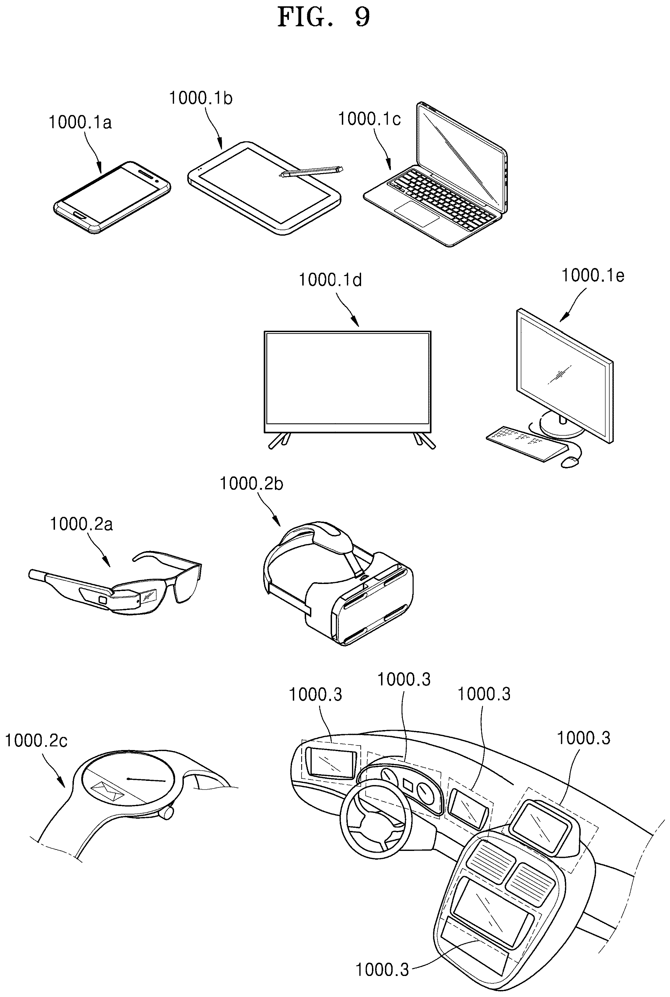

FIG. 9 shows schematic diagrams of electronic devices according to various embodiments.

Referring to FIG. 9, various electronic devices to which the display device 1 according to embodiments is applied may include not only image display electronic devices such as a smart phone 1000.1a, a tablet PC 1000.1b, a laptop 1000.1c, a TV 1000.1d, and a desk monitor 1000.1e, but also wearable electronic devices including display modules such as smart glasses 1000.2a, a head mounted display 1000.2b, and a smart watch 1000.2c, and a vehicle electronic device 1000.3 including display modules such as a dashboard, center fascia, or a center information display (CID) arranged on a car instrument panel, and a room mirror display.

According to embodiments of the present disclosure, a display device, a method of manufacturing thereof, and an electronic device can be implemented wherein reliability is improved by removing a common electrode from a portion of a pixel definition film, and processing is simplified by directly forming a color filter on a light-emitting element.

The effects achievable through the present disclosure shall not be limited to the effects described above, and additional technical effects not expressly described herein shall be readily apparent to those having ordinary skill in the art from the description of the disclosure set forth below.

Each embodiment described herein may be implemented independently; provided, however, that the structures of the respective embodiments may be implemented in combination with other embodiments.

Although the present disclosure has been described with reference to the illustrated embodiments, such embodiments are examples only, and it will be appreciated by those having ordinary skill in the relevant art that various modifications and equivalent alternative embodiments are possible. Accordingly, the true technical scope of protection of the present disclosure shall be determined by the appended claims.

The specific implementations described in the embodiments constitute embodiments and shall not be construed as limiting the scope of the embodiments in any manner. Further, absent specific terminology such as "essential" or "critical," components described herein may not constitute elements necessary for implementation of the present disclosure.

The term "the" and similar referential terminology appearing in the specification of the embodiments (particularly in the claims) shall be construed as encompassing both singular and plural forms. Furthermore, where ranges are specified in the embodiments, unless expressly stated otherwise, the disclosure shall be deemed to encompass implementations utilizing individual values within said ranges, as if each individual value within said ranges had been explicitly set forth in the detailed description. Moreover, with respect to steps comprising methods according to the embodiments, absent explicit ordering or contrary statements, the steps may be performed in any suitable sequence.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device (1) comprising:
a substrate (110);
a thin film transistor (TFT) on the substrate (110);
an insulating layer (114) on the thin film transistor (TFT);
a light-emitting element (PX) positioned on the insulating layer (114) and including a pixel electrode (130) electrically connected to the thin film transistor (TFT), a common electrode (150) facing the pixel electrode (130), and an interlayer (140) between the pixel electrode (130) and the common electrode (150), and
a pixel definition film (160) positioned on the insulating layer (114) and covering an edge of the pixel electrode (130) to define a light-emitting area (LA) of the light-emitting element (PX),
wherein the common electrode (150) includes a first common electrode (151) in the light-emitting area (LA), a second common electrode (152) spaced apart from the first common electrode (151) and surrounding the light-emitting area (LA) and positioned on the pixel definition film (160), and a bridge electrode (153) connecting the first common electrode (151) to the second common electrode (152).

2. The display device (1) of claim 1, wherein the pixel definition film (160) further comprises a spacer (161) in an isolation area (IA) defined between the first common electrode (151) and the second common electrode (152).

3. The display device (1) of claim 2, wherein the spacer (161) is configured to discontinuously surround the light-emitting area (LA) and the bridge electrode (153) located in an area where the spacer (161) is disconnected.

4. The display device (1) of any one of claims 1 to 3, wherein a width (d) of the bridge electrode (153) along a direction perpendicular to a direction in which the first common electrode (151) and the second common electrode (152) are connected to each other is 2 µm to 10 µm.

5. The display device (1) of any one of claims 1 to 4, wherein the bridge electrode (153) connected to the first common electrode (151) is provided as multiple bridge electrodes (153), and
the plurality of the bridge electrodes (153) are arranged spaced apart from each other in a direction perpendicular to the direction in which the first common electrode (151) and the second common electrode (152) are connected to each other.

6. The display device (1) of any one of claims 1 to 5, wherein:
(i) the pixel definition film (160) has liquid repellency; and/or
(ii) the pixel definition film (160) includes a light-blocking material.

7. The display device (1) of any one of claims 1 to 6, further comprising a color filter part (CF) arranged on the light-emitting element (PX).

8. The display device (1) of claim 7, wherein:
(i) the color filter part (CF) is located in the light-emitting area (LA); and/or
(ii) the color filter part (CF) has an upwardly convex shape; and/or
(iii) the display device (1) further comprises a thin-film encapsulation layer (TFE) arranged on the color filter part (CF).

9. A method of manufacturing a display device (1), the method comprising:
forming a thin film transistor (TFT) on a substrate (110), and an insulating layer (114) on the thin film transistor (TFT); and
forming, on the insulating layer (114), a light-emitting element (PX) including a pixel electrode (130) electrically connected to the thin film transistor (TFT), a common electrode (150) facing the pixel electrode (130), and an interlayer (140) between the pixel electrode (130) and the common electrode (150), and a pixel definition film (160) covering an edge of the pixel electrode (130) to define a light-emitting area (LA) of the light-emitting element (PX),
wherein the common electrode (150) includes:
a first common electrode (151) in the light-emitting area (LA),
a second common electrode (152) spaced apart from the first common electrode (151) and surrounding the light-emitting area (LA) and positioned on the pixel definition film (160), and
a bridge electrode (153) connecting the first common electrode (151) to the second common electrode (152).

10. The method of claim 9, wherein
the forming the light-emitting element (PX) and the pixel definition film (160) comprises:
forming the pixel electrode (130);
forming the pixel definition film (160) on the edge of the pixel electrode (130) using a half-tone mask;
forming the interlayer (140) on the pixel electrode (130); and
forming the common electrode (150) on the pixel definition film (160) and the interlayer (140).

11. The method of claim 10, further comprising,
after the forming the common electrode (150) on the pixel definition film (160) and the interlayer (140), forming a spacer (161) by patterning a common electrode (150) on one area of the pixel definition film (160),
wherein the spacer (161) is disposed between the first common electrode (151) and the second common electrode (152), optionally further comprising,
after the forming the spacer (161), treating the spacer (161) with a plasma having liquid repellency.

12. The method of any one of claims 9 to 11, further comprising:
after the forming the light-emitting element (PX) and the pixel definition film (160), forming a color filter part (CF) on the first common electrode (151).

13. The method of claim 11 or claim 12, wherein a space between the first common electrode (151) and the second common electrode (152) is defined as an isolation area (IA), and
the spacer (161) configured to discontinuously surround the light-emitting area (LA) and the bridge electrode (153) located in an area where the spacer (161) is disconnected, are arranged in the isolation area (IA).

14. The method of any one of claims 9 to 13, wherein:
(i) a width (d) of the bridge electrode (153) along a direction perpendicular to a direction in which the first common electrode (151) and the second common electrode (152) are connected to each other is 2 µm to 10 µm; and/or
(ii) the pixel definition film (160) has liquid repellency.

15. An electronic device (1000) comprising:
a display device (1), one or more processors (1200), a memory (1300), and a power module (1400), wherein
the display device (1) comprises:
a substrate (110);
a thin film transistor (TFT) on the substrate (110);
an insulating layer (114) on the thin film transistor (TFT);
a light-emitting element (PX) positioned on the insulating layer (114) and including a pixel electrode (130) electrically connected to the thin film transistor (TFT), a common electrode (150) facing the pixel electrode (130), and an interlayer (140) between the pixel electrode (130) and the common electrode (150); and
a pixel definition film (160) positioned on the insulating layer (114) and covering an edge of the pixel electrode (130) to define a light-emitting area (LA) of the light-emitting element (PX),
wherein the common electrode (150) includes a first common electrode (151) in the light-emitting area (LA), a second common electrode (152) spaced apart from the first common electrode (151) and surrounding the light-emitting area (LA) and positioned on the pixel definition film (160), and a bridge electrode (153) connecting the first common electrode (151) to the second common electrode (152).
